# DEMANDE DE BREVET EUROPEEN

(11) **EP 0 982 855 A1**
(43) Date de publication de la demande: **01.03.2000**
(21) Numéro de dépôt: 99402124.4
(22) Date de dépôt: 26.08.1999
(51) Int. Cl.: H03H 7/12

(54) **Procédé pour analyser le spectre d'un signal de transmission d'un système de radiocommunication ainsi qu'à un dispositif pour sa mise en oeuvre**

(30) Priorité: 27.08.1998 FR 9810761
(71) Demandeur: ALCATEL, 75008 Paris (FR)
(72) Inventeur: Danet, Olivier, 95520 Osny (FR)
(74) Mandataire: Lamoureux, Bernard

(57) **Abrégé**

Procédé pour analyser le spectre d'un signal de transmission d'un système de radiocommunication, ayant une fréquence porteuse donnée, dans lequel :
- on répartit le signal de transmission (S) de manière à obtenir un premier et un second signaux intermédiaires (S₁, S₂) ;
- on applique un déphasage, à ladite fréquence porteuse donnée, sur l'un au moins des signaux intermédiaires de sorte qu'à cette fréquence, les signaux intermédiaires soient déphasés de 180° l'un par rapport à l'autre ;
- on recombine les signaux intermédiaires déphasés, de manière à former un signal recombiné (S') dans lequel est rejetée la partie de signal qui est transmise à la fréquence porteuse donnée ;
- on analyse le spectre du signal recombiné (S').

## Description

L'invention se rapporte à un procédé pour analyser le spectre d'un signal de transmission d'un système de radiocommunication ainsi qu'à un dispositif pour sa mise en oeuvre.

L'invention est plus particulièrement appliquée, mais non exclusivement, aux terminaux mobiles de tout réseau de radiocommunication, notamment du type GSM (système global pour les communications mobiles), DCS (système de communication numérique), PCS (service de communication personnelle), DECT (système européen de télécommunication numérique sans fil).

L'analyse du spectre du signal émis par un terminal mobile fait partie de l'une des étapes du test d'un terminal mobile avant sa mise en circulation.

Cette étape consiste à vérifier que les fréquences autres que la fréquence porteuse, sont émises à un niveau de puissance inférieur à un seuil déterminé, afin d'éviter l'émission de parasites.

Pour réaliser cette étape, il est indispensable de rejeter la fréquence porteuse qui entraîne une saturation de l'analyseur de spectre, compte tenu de sa configuration pour la phase de test.

On entend par fréquence porteuse, la fréquence du signal utile.

Selon l'art antérieur, on utilise un filtre pour rejeter la fréquence porteuse. Le filtre ayant pour inconvénient de désadapter la ligne de transmission du signal, il est indispensable de le coupler à un atténuateur.

Cependant, l'atténuation est effectuée sur l'ensemble du signal. Ainsi, les parties de signal dont les fréquences doivent être analysées sont également atténuées.

En outre, en dehors d'une certaine gamme de fréquences (10 MHz - 1 GHz), les pertes en transmission sont très grandes et dégradent la précision de la mesure. Ainsi, pour les fréquences situées en dehors de cette gamme, un montage différent est nécessaire : un filtre passe-haut doit être substitué au couple filtre réjecteur-atténuateur.

L'invention a donc pour objet un procédé du type précité, qui soit simple à mettre en oeuvre et donne un résultat précis pour tout type de signal de transmission transmis dans une large bande de fréquences.

A cet effet, l'invention propose un procédé pour analyser le spectre d'un signal de transmission d'un système de radiocommunication, ayant une fréquence porteuse donnée, dans lequel :
- on répartit le signal de transmission de manière à obtenir un premier et un second signaux intermédiaires;
- on applique un déphasage, à ladite fréquence porteuse donnée, sur l'un au moins des signaux intermédiaires de sorte qu'à cette fréquence, les signaux intermédiaires soient déphasés de 180° l'un par rapport à l'autre ;
- on recombine les signaux intermédiaires déphasés, de manière à former un signal recombiné (S') dans lequel est rejeté la partie de signal qui est transmise à la fréquence porteuse donnée ;
- on analyse le spectre du signal recombiné (S').

Est en outre mis en oeuvre un dispositif pour analyser le spectre d'un signal de transmission d'un système de radiocommunication, ayant une fréquence porteuse donnée.

Ce dispositif comporte un circuit recevant en entrée ledit signal de transmission et étant apte à rejeter dans ledit signal de transmission, la partie de signal qui est transmise à ladite fréquence porteuse, le circuit comportant :
■ des moyens de répartition pour répartir le signal de transmission en deux signaux intermédiaires ;
■ des moyens de déphasage pour appliquer, à ladite fréquence porteuse, un déphasage sur l'un au moins des signaux intermédiaires de sorte qu'à cette fréquence, les signaux intermédiaires soient déphasés de 180° l'un par rapport à l'autre ;
■ des moyens de recombinaison pour recombiner les deux signaux intermédiaires déphasés, de manière à former un signal recombiné dans lequel, à ladite fréquence porteuse, la partie de signal est rejetée ;
les moyens de recombinaison étant reliés aux moyens de répartition par deux voies de transmission (5, 6) véhiculant chacune un signal intermédiaire.

Le circuit comporte en outre un analyseur de spectre, connecté au circuit de manière à recevoir le signal recombiné à analyser.

Dans la suite du texte, on entend par signal de transmission tout signal émis ou reçu par le système de radiocommunication.

L'invention sera mieux comprise à la lumière de la description détaillée qui suit en référence aux dessins annexés.

La figure 1 représente le schéma bloc d'un premier mode de réalisation du circuit réjecteur de l'invention, dans lequel les moyens de déphasage sont montés sur une seule voie de transmission.

La figure 2 représente le schéma détaillé d'une première variante de la figure 1.

La figure 3 représente le schéma simplifié d'une deuxième variante de la figure 1.

La figure 4 représente le schéma détaillé d'un deuxième mode de réalisation du circuit réjecteur de l'invention, dans lequel les moyens de déphasage sont montés sur deux voies de transmission.

La figure 5 représente un schéma détaillé du dispositif de l'invention comprenant une variante du circuit réjecteur de la figure 4.

La figure 6 représente une courbe S_{R} représentant le rapport (en dB) entre le signal de transmission S et le signal recombiné S' sur une bande de fréquences comprise entre 5 MHz et 2 GHz.

La figure 7 représente la courbe S_{R} de la figure 6 sur une bande de fréquences réduite, allant de 847,4 MHz à 957,4 MHz, ainsi que la courbe Sₚ représentant la perte par désadaptation.

On décrit ci-après un circuit réjecteur 1, alimenté, en entrée I, par un signal de transmission S d'un système de radiocommunication.

Le système de radiocommunication comprend un terminal mobile de tout réseau de radiocommunication, notamment du type GSM, DCS ou PCS, ou autre.

Dans d'autres modes de réalisation, on peut envisager que le signal de transmission appartienne à un autre système de radiocommunication.

Ce circuit réjecteur 1 est apte à émettre en sortie O, un signal dit recombiné S', correspondant au signal de transmission S dans lequel une partie de signal S_{d} transmise à une fréquence donnée f_{d} a été rejetée.

Dans la suite du texte, on entend par extrémité amont, l'extrémité par laquelle entre le signal et par extrémité aval, l'extrémité par laquelle sort le signal.

Le circuit réjecteur 1 comporte des moyens de répartition 2 aptes à répartir le signal de transmission S, en deux signaux intermédiaires S₁ et S₂.

Dans les modes de réalisation représentés, les moyens de répartition 2 sont un répartiteur du type Wilkinson, divisant et répartissant le signal de transmission S en deux signaux intermédiaires sensiblement égaux.

Il est entendu que peuvent être utilisés d'autres répartiteurs exerçant les mêmes fonctions que le répartiteur précité.

On peut également envisager des moyens de répartition 2 répartissant le signal de transmission S en deux signaux intermédiaires S₁ et S₂ non égaux, c'est-à-dire ayant un niveau de puissance différent, et donc une amplitude différente.

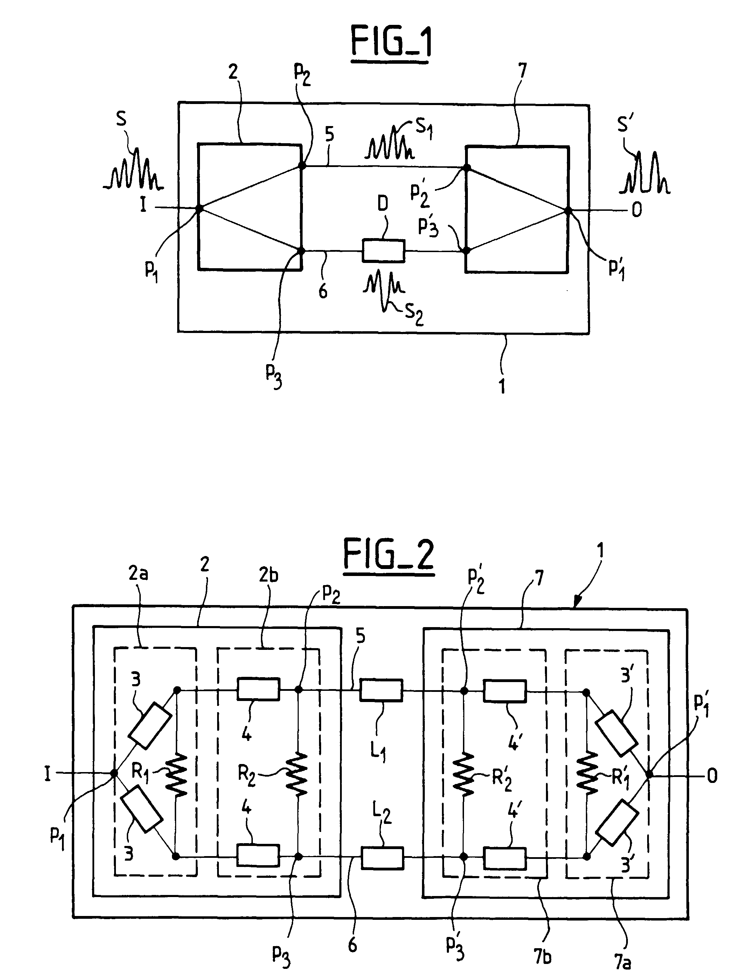

Suivant le mode de réalisation des figures 1 à 5, les moyens de répartition 2 comportent deux parties 2a, 2b. La première partie 2a a pour fonction de diviser et répartir le signal de transmission S. En outre, la deuxième partie 2b a une fonction de transformateur d'impédance.

Ces moyens de répartition 2 permettent d'obtenir deux signaux intermédiaires S₁ et S₂ dont le niveau de puissance est sensiblement égal à la moitié de celui du signal de transmission S.

Pour accroître les capacités du circuit réjecteur 1, il est judicieux d'augmenter la largeur de bande des moyens de répartition 2, ce qui peut être réalisé en cascadant au moins un transformateur d'impédance du type de la deuxième partie 2b.

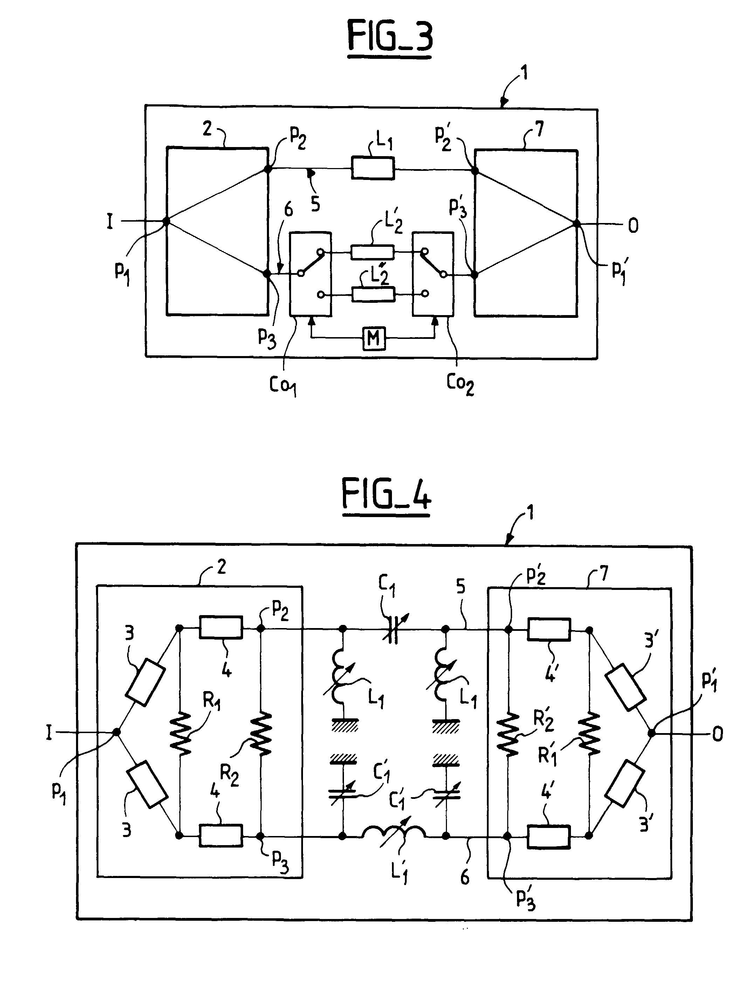

Comme cela est visible notamment sur la figure 2, la première partie 2a comporte deux premières lignes de transmission 3 de longueur et d'impédance caractéristique sensiblement identiques, ainsi qu'une première résistance R₁.

A leur extrémité amont, les premières lignes de transmission 3 sont reliées par un point commun p₁ à l'entrée I du circuit réjecteur 1.

A leur extrémité aval, elles sont reliées entre elles par la première résistance R₁, qui exerce notamment une fonction d'isolation en terme de puissance.

La deuxième partie 2b comporte deux deuxièmes lignes de transmission 4 de longueur et d'impédance caractéristique sensiblement identiques, ainsi qu'une deuxième résistance R₂.

Chaque première ligne de transmission 3 est reliée en série à une deuxième ligne de transmission 4.

Les extrémités amont des deuxièmes lignes de transmission 4 sont reliées entre elles par la première résistance R₁, tandis que leurs extrémités aval sont reliées entre elles par la deuxième résistance R₂.

Dans le mode de réalisation représenté, les lignes de transmission 3 et 4 présentent une même longueur, de l'ordre du quart de la longueur d'onde du signal de transmission S.

En revanche, l'impédance caractéristique des premières lignes de transmission 3 est de préférence différente de celle des deuxièmes lignes de transmission 4.

Les moyens de répartition 2 comportent une entrée, formée par le point commun p₁, et deux sorties, formées chacune par un point commun p₂, respectivement p₃, reliant l'extrémité aval d'une deuxième ligne de transmission 4 à la deuxième résistance R₂.

Chaque point commun p₂ et p₃ est relié à une voie de transmission 5, 6.

Les voies de transmission véhiculent respectivement un signal intermédiaire S₁, S₂.

La deuxième résistance R₂ des moyens de répartition 2, a notamment pour rôle d'isoler, en terme de puissance, les deux voies de transmission 5, 6 l'une par rapport à l'autre.

Dans le mode de réalisation de la figure 2, chaque voie de transmission 5, 6 comporte une ligne de transmission, respectivement L₁, L₂.

Les lignes L₁ et L₂ ont chacune une impédance caractéristique de l'ordre de 50 ohms.

En outre, l'une des lignes L₁ présente une longueur l qui est fonction de la fréquence porteuse f₀ du signal de transmission S. Tandis que l'autre ligne L₂ présente une longueur égale à (l + λ_{d}/2), où λ_{d} est la longueur d'onde du signal de transmission S à la fréquence donnée f_{d}.

Les caractéristiques de la ligne L₂ appliquent ainsi un déphasage de 180° sur la voie de transmission 6. La ligne L₂ ainsi configurée forme les moyens de déphasage D représentés à la figure 1.

Bien entendu, dans une variante, les moyens de déphasage D peuvent être montés sur l'autre voie de transmission 5.

On peut également envisager que la voie de transmission 5 ne comporte pas de ligne de transmission, tandis que la voie de transmission 6 comporte une ligne de transmission dont la longueur est fonction de la fréquence donnée f_{d} et permet le déphasage de 180° entre les deux voies de transmission.

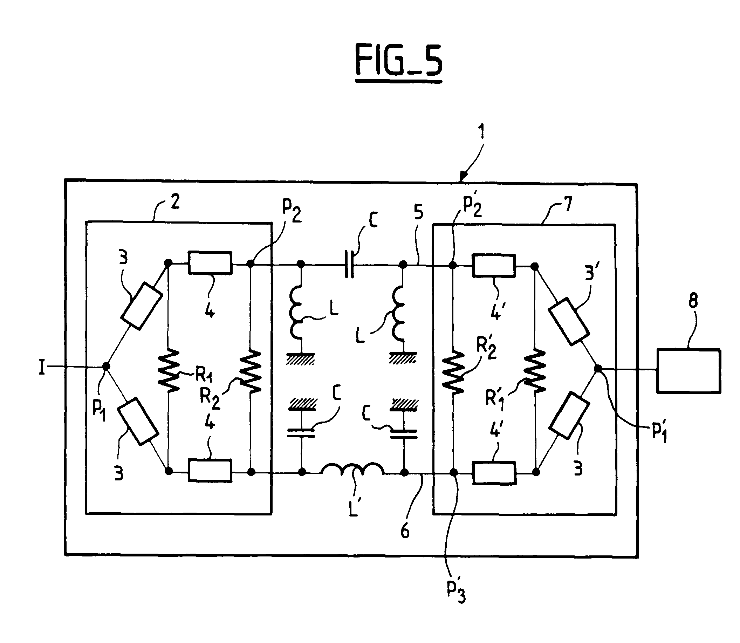

Dans le mode de réalisation de la figure 5, la voie de transmission 5 comporte un circuit passe-bas LC apte à déphaser le signal intermédiaire S₁ de -90° à la fréquence donnée f_{d}. En outre, la voie de transmission 6 comporte un circuit passe-haut L'C' apte à déphaser le signal intermédiaire S₂ de +90° à la fréquence donnée f_{d}.

Ainsi, à la fréquence donnée f_{d}, il existe un déphasage de 180° entre le signal intermédiaire S₂ de la voie de transmission 6 et le signal intermédiaire S₁ de la voie de transmission 5.

Il est entendu que, dans un autre mode de réalisation comportant des éléments discrets, seul le signal intermédiaire S₁, S₂ de l'une des voies de transmission 5, 6 peut être déphasé de 180°, le signal intermédiaire S₂, S₁ de l'autre voie de transmission 6, 5 restant inchangé. Les composants des voies de transmission, et leur combinaison, seront alors adaptés en conséquence.

On comprend donc que les moyens de déphasage D peuvent comporter soit au moins une ligne de transmission, soit des éléments discrets, dont les caractéristiques sont fonction de la fréquence donnée f_{d}.

A leur extrémité aval, les deux voies de transmission 5, 6 sont reliées à des moyens de recombinaison 7.

Ces moyens de recombinaison 7 ont pour fonction de recombiner les deux signaux intermédiaires S₁ et S₂ de manière à former un signal recombiné S'.

La recombinaison des deux signaux intermédiaires S₁ et S₂, déphasés de 180° l'un par rapport à l'autre à la fréquence donnée f_{d}, annule sensiblement l'amplitude de la partie de signal S_{d} à la fréquence donnée f_{d}.

Dans les modes de réalisation représentés, les moyens de recombinaison 7 sont sensiblement identiques structurellement aux moyens de répartition 2. Cela permet d'adapter plus facilement les moyens de recombinaison 7 par rapport aux moyens de répartition 2, quels qu'ils soient.

Les moyens de recombinaison sont réalisés de sorte que le signal de transmission S soit reconstitué, la partie de signal S_{d} étant rejetée.

Dans les présents modes de réalisation, l'extrémité aval de chaque voie de transmission 5, 6 forme une entrée des moyens de recombinaison 7.

Les moyens de recombinaison 7 comportent deux portions 7a, 7b. La première portion 7a a pour fonction de recombiner les deux signaux intermédiaires S₁ et S₂ après que la deuxième portion 7b ait exercé une transformation d'impédance.

De même que pour les moyens de répartition 2, on peut envisager de cascader, en aval de la deuxième portion 7b, au moins un transformateur d'impédance supplémentaire du même type.

Comme cela est visible notamment sur la figure 2, la deuxième portion 7a comporte deux premières lignes de transmission 3' de longueur et d'impédance caractéristique sensiblement identiques, ainsi qu'une première résistance R₁'.

A leur extrémité aval, les premières lignes de transmission 3' sont reliées par un point commun p₁' à la sortie O du circuit réjecteur 1.

A leur extrémité amont, elles sont reliées entre elles par la première résistance R₁'.

La deuxième portion 7b comporte deux deuxièmes lignes de transmission 4' de longueur et d'impédance caractéristique sensiblement identiques, ainsi qu'une deuxième résistance R₂'.

Chaque première ligne de transmission 3' est reliée en série à une deuxième ligne de transmission 4'.

Les extrémités aval des deuxièmes lignes de transmission 4' sont reliées entre elles par la première résistance R₁', tandis que leurs extrémités amont sont reliées entre elles par la deuxième résistance R₂'.

Dans le mode de réalisation représenté, les lignes de transmission 3' et 4' présentent une même longueur, de l'ordre du quart de la longueur d'onde du signal de transmission S.

En revanche, l'impédance caractéristique des premières lignes de transmission 3' est de préférence différente de celle des deuxièmes lignes de transmission 4'.

Dans les présents modes de réalisation, les lignes de transmission 3 et 4 des moyens de répartition 2 sont sensiblement identiques respectivement aux lignes de transmission 3' et 4' des moyens de recombinaison 7. Il en est de même s'agissant des résistances R₁, R₂ et R₁', R₂'.

L'extrémité amont de chaque deuxième ligne de transmission 4' forme avec une extrémité respective de la deuxième résistance R₂', respectivement un point commun p₂', p₃'.

Chaque point commun p₂' et p₃' est relié à une voie de transmission 5, 6, et forme ainsi une entrée des moyens de recombinaison 7.

Sur la figure 1, est représentée schématiquement l'allure des courbes de signal à chaque étape du procédé de réjection.

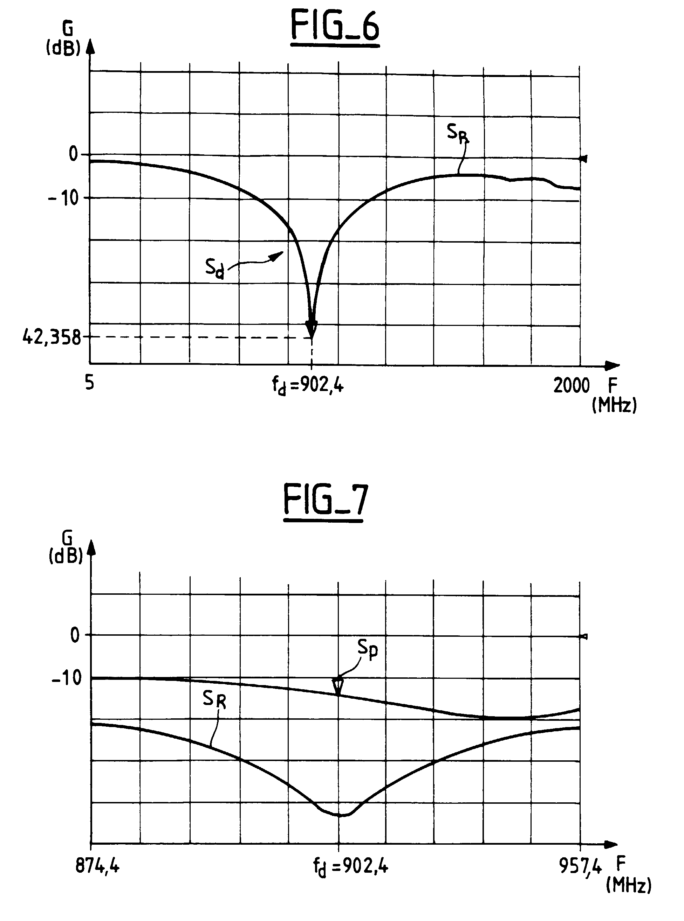

En outre, la figure 6 montre le rapport entre le signal recombiné S' et le signal de transmission S. La fréquence donnée f_{d}, à laquelle la partie de signal correspondante S_{d} est rejetée, est de 902,4 MHz.

La figure 7 montre la même courbe S_{R} sur une bande de fréquences réduite ainsi que la courbe Sₚ de la perte par désadaptation.

On remarque que la perte en puissance par réflexion est faible comparativement à celle engendrée dans les circuits réjecteurs classiques qui sont généralement fortement désadaptés. L'analyse du signal peut alors être plus réaliste.

Cette caractéristique est due au fait que, le circuit 1 reste adapté à une impédance caractéristique sensiblement constante en fonction de la fréquence, entre l'entrée I et la sortie O.

Le circuit réjecteur 1 est utilisé dans le cadre du test d'un terminal mobile (non représenté) apte à fonctionner dans un réseau de radiocommunication déterminé.

Une étape du test consiste à analyser le spectre du signal émis par le terminal mobile.

On connecte alors la sortie de l'émetteur du terminal mobile à l'entrée I du circuit réjecteur 1 et l'entrée d'un analyseur de spectre 8 à la sortie O du circuit réjecteur 1 (figure 5).

Dans ces conditions, l'analyseur de spectre 8 doit vérifier que les fréquences autres que la fréquence porteuse f₀ du signal de transmission S du terminal mobile, soient émises à un niveau de puissance suffisamment faible.

Il est donc nécessaire de rejeter la partie de signal transmise à la fréquence porteuse f₀ du signal de transmission S, c'est-à-dire le signal utile.

La fréquence donnée f_{d}, utilisée dans le circuit réjecteur 1, est alors égale à la fréquence porteuse f₀ du signal de transmission S, à savoir la fréquence du signal utile.

L'analyseur 8 analyse alors le spectre du signal recombiné S' dans lequel le signal utile est rejeté.

En outre, le circuit réjecteur 1 est configuré en fonction de cette fréquence.

Le circuit réjecteur 1 peut également être utilisé dans le cadre du fonctionnement d'un terminal mobile dans un réseau de radiocommunication déterminé, autorisant l'émission et la réception de signaux respectivement dans une bande de fréquences déterminée.

En effet, le circuit réjecteur 1 permettra la réjection d'une partie de signal transmise à une fréquence parasite, qui correspond ici à la fréquence donnée f_{d}.

Dans l'hypothèse où cette fréquence parasite diffère d'un terminal mobile à l'autre, on utilise des moyens de déphasage D à fréquence variable, fonctionnant en fonction de la fréquence donnée f_{d}.

Ainsi, qu'ils soient sur une seule voie de transmission 5, 6 ou sur les deux, les moyens de déphasage D sont adaptés de manière à s'ajuster à la fréquence parasite du terminal mobile concerné.

Il est entendu que ces moyens de déphasage D à fréquence variable peuvent également être utilisés dans le dispositif d'analyse du spectre qui vient d'être décrit. Ils trouvent notamment leur intérêt dès lors que la fréquence du signal utile est variable.

La figure 4 représente un mode de réalisation du circuit réjecteur 1 comportant des moyens de déphasage à fréquence variable, montés sur les deux voies de transmission 5, 6.

Ce circuit réjecteur 1 correspond sensiblement au circuit réjecteur de la figure 5. Seuls les bobines L, L' et les condensateurs C, C' des circuits passe-bas et passe-haut ont été remplacés respectivement par des bobines variables L₁, L₁' et des condensateurs variables C₁, C₁'.

La figure 3 représente un autre mode de réalisation du circuit réjecteur 1 comportant des moyens de déphasage D à fréquence variable, montés sur une seule voie de transmission 6.

Ce circuit réjecteur 1 correspond sensiblement à celui de la figure 2. Seule la ligne de transmission L₂ a été supprimée et remplacée par deux lignes de transmission L₂' et L₂' connectées de part et d'autre à un premier commutateur Co₁ et un deuxième commutateur Co₂.

Le premier commutateur Co₁ est relié au point commun p₃, tandis que le deuxième commutateur Co₂ est relié au point commun p₃'.

Les commutateurs Co₁ et Co₂ sont aptes à établir la liaison entre les moyens de répartition 2 et les moyens de recombinaison 7 par l'une ou l'autre ligne de transmission, L₂' ou L₂".

Ces commutateurs Co₁ et Co₂ sont commandés simultanément par des moyens de commande M.

Il est entendu que dans les variantes des figures 3 et 4, les moyens de répartition 2 et les moyens de recombinaison 7 peuvent être différents de ceux des modes de réalisation décrits précédemment.

Les circuits réjecteurs 1 comportant des moyens de déphasage D à fréquence variable peuvent également être utilisés dans le cadre du fonctionnement d'un terminal mobile apte à fonctionner alternativement dans deux réseaux de radiocommunication autorisant les fréquences dans deux bandes distinctes.

Ainsi, par exemple, pour un terminal mobile apte à fonctionner dans les réseaux GSM (bande 900 MHz) et DCS (bande 1800 MHz) et utilisant un seul synthétiseur, il conviendra de supprimer la partie de signal comportant la fréquence porteuse de la bande du réseau qui doit être quittée, pour n'autoriser que les fréquences de la bande de l'autre réseau.

Le circuit réjecteur 1 sera alors relié à la sortie du synthétiseur et adapté en fonction des fréquences données à rejeter.

## Revendications

1. Procédé pour analyser le spectre d'un signal de transmission d'un système de radiocommunication, ayant une fréquence porteuse donnée, caractérisé en ce que :
- on répartit le signal de transmission (S) de manière à obtenir un premier et un second signaux intermédiaires (S₁, S₂) ;
- on applique un déphasage, à ladite fréquence porteuse donnée, sur l'un au moins des signaux intermédiaires de sorte qu'à cette fréquence, les signaux intermédiaires soient déphasés de 180° l'un par rapport à l'autre ;
- on recombine les signaux intermédiaires déphasés, de manière à former un signal recombiné (S') dans lequel est rejetée la partie de signal qui est transmise à la fréquence porteuse donnée ;
- on analyse le spectre du signal recombiné (S').

2. Procédé selon la revendication 1, caractérisé en ce que le signal de transmission (S) est réparti en deux signaux intermédiaires (S₁, S₂) sensiblement égaux.

3. Procédé selon la revendication 1 ou 2, caractérisé en ce que l'un seulement des signaux intermédiaires est déphasé à 180°.

4. Dispositif pour analyser le spectre d'un signal de transmission d'un système de radiocommunication, ayant une fréquence porteuse donnée, caractérisé en ce qu'il comporte:
- un circuit (1) recevant en entrée (I) ledit signal de transmission et étant apte à rejeter dans ledit signal de transmission (S), la partie de signal qui est transmise à ladite fréquence porteuse (fₒ), le circuit comportant :
■ des moyens de répartition (2) pour répartir le signal de transmission (S) en deux signaux intermédiaires (S₁, S₂) ;
■ des moyens de déphasage (D) pour appliquer, à ladite fréquence porteuse, un déphasage sur l'un au moins des signaux intermédiaires (S₁, S₂) de sorte qu'à cette fréquence, les signaux intermédiaires soient déphasés de 180° l'un par rapport à l'autre ;
■ des moyens de recombinaison (7) pour recombiner les deux signaux intermédiaires déphasés, de manière à former un signal recombiné (S') dans lequel, à ladite fréquence porteuse, la partie de signal est rejetée ;
les moyens de recombinaison (7) étant reliés aux moyens de répartition (2) par deux voies de transmission (5, 6) véhiculant chacune un signal intermédiaire (S₁, S₂);
et
- un analyseur de spectre (8), connecté au circuit (1) de manière à recevoir le signal recombiné (S') à analyser.

5. Dispositif selon la revendication 4, caractérisé en ce que les moyens de répartition (2) comportent un répartiteur apte à diviser le signal de transmission (S) en deux signaux intermédiaires (S₁, S₂) sensiblement égaux.

6. Dispositif selon la revendication 4 ou 5, caractérisé en ce que les moyens de déphasage (D) sont montés sur l'une au moins des voies de transmission (5, 6).

7. Dispositif selon la revendication 6, caractérisé en ce que les moyens de déphasage (D) comprennent au moins une ligne de transmission (L₂, L'₂, L"₂) présentant une longueur fonction de la fréquence porteuse (f₀).

8. Dispositif selon la revendication 6, caractérisé en ce que l'une des voies de transmission (5, 6) comporte un circuit passe-bas (LC, L₁C₁) apte à déphaser le signal intermédiaire correspondant (S₁) de -90° à la fréquence porteuse (f₀), tandis que l'autre voie de transmission comporte un circuit passe-haut (L' C', L'₁ C'₁) apte à déphaser le signal intermédiaire correspondant (S₂) de +90° à la fréquence porteuse (f₀).

9. Dispositif selon l'une des revendications 4 à 8, caractérisé en ce que les moyens de déphasage (D) sont des moyens de déphasage à fréquence variable.

10. Dispositif selon l'une des revendications 4 à 9, caractérisé en ce que, entre son entrée (I) et sa sortie (O), le circuit (1) est adapté à une impédance caractéristique sensiblement constante en fonction de la fréquence.
